# EUROPEAN PATENT SPECIFICATION

(11) **EP 0 541 401 B1**
(45) Date of publication and mention of the grant of the patent: **19.02.1997**
(21) Application number: 92310218.0
(22) Date of filing: 09.11.1992
(51) Int. Cl.: B05D 5/02, B05D 1/00

(54) **Method for the formation of two-dimensional particle arrangements**
Verfahren zur Herstellung einer zweidimensionalen Partikelanordnung
Procédé pour former des structures bidimensionnelles avec des particules

(30) Priority: 08.11.1991 JP 293471/91
(43) Date of publication of application: 12.05.1993
(73) Proprietor: RESEARCH DEVELOPMENT CORPORATION OF JAPAN, Chiyoda-ku, Tokyo (JP); Nagayama, Kuniaki, Suginami-ku, Tokyo (JP)
(72) Inventor: Nagayama, Kuniaki, Suginami-ku, Tokyo (JP); Ivanov, Ivan, Sofia 1126 (BG)
(74) Representative: Skailes, Humphrey John

(56) References cited:
- GB-A- 686 259
- GB-A- 745 814
- GB-A- 1 326 829
- US-A- 2 776 908
- US-A- 3 398 018

## Description

The present invention relates to a method for the formation of two-dimensional structures composed of fine particles. The method provides new functional materials which may be useful in various areas such as electronics, biomaterials, ceramics and metal materials, and is also of interest in places where the gravity is non-existent, such as space.

Various methods are known for forming assembled structures of atoms, molecules or fine particles. The known methods, for example, for forming two-dimensional atomic or molecular arrangements on a plate include vacuum deposition, sputtering, electroplating, and LB film forming. The known methods for two-dimensionally arranging fine particles (protein, oxides, metals, latex or polymers) include the application of a particle emulsion on a flat surface (such as the spin coat process), the spreading of powdered particles on a flat surface (such as atomizing), and the precipitation of particles from a dispersive medium onto a liquid-vapour interface or a liquid-liquid interface. These methods for shaping the structure with particles are very important for various solid sensors, magnetic recording media, electronic devices, catalysts and other applications.

Rapid formation and control to a high degree of accuracy of the structures are not however easy to achieve. The methods so far tried for this purpose in practice have serious problems. In the above-mentioned methods, for example, it is often difficult to control the film thickness, making it impossible to form a perfectly flat two-dimensional film. In the spreading method, while it is easy to control the film thickness, a problem is that a film of irregular thickness is always formed. The precipitation method, permitting formation of a two-dimensional film with a single layer of particles, cannot avoid the problem of irregularities. A method for uniformly assembling particles as a single layer has not as yet been established.

US-A 3398018 describes a method of coating an article comprising depositing on the surface of the article an aqueous dispersion of particles and a film-forming resin, and subsequently drying the dispersion to provide a transparent coating.

The present invention has its object to provide a novel high-accuracy and high-efficiency method for the formation of two-dimensional particle structures, which solves the problem of the conventional methods as discussed above, and permits the uniform and orderly arrangement of particles in a single layer in a rapid manner.

More particularly, the invention provides a method for the formation of particle arrangements, which comprises deploying a dispersion of the particles in a liquid medium on the surface of a substrate, and forming a thin liquid film and controlling thickness thereof to the order of the particle size or less by reducing the thickness of the liquid medium, thereby causing or allowing particles to assemble to form a two-dimensional structure.

### BRIEF DESCRIPTION OF THE DRAWINGS

Fig. 1 is a diagram illustrating the formation of crystal nuclei under the effect of lateral capillary force (lateral immersion force) in the method of the invention;
Fig. 2 is a diagram illustrating the laminar flow effect in the course of particle structure growth in the method of the invention;
Fig. 3(a) (b) and (c) are photographs which illustrate the suspended state and the particle growth process on a glass plate, respectively, of latex particles in water; and
Fig. 4 is a photograph illustrating the product obtained by the two-dimensional assembly of particles on the surface of Hg as a liquid substrate.

### DETAILED DESCRIPTION OF THE INVENTION

The formation of initial particle (crystal) nuclei and the growth process in the course of formation of particle structures in the invention, are discussed below.

While various factors are conceivable for the nucleation process, it is attributable mainly to the attractive force between particles and the lateral capillary force (lateral immersion force), the presence of which has been established by the inventors.

The lateral capillary force (lateral immersion force) will now be described. It is distinguished from the normal capillary force in the vertical direction (in balance with gravity). The vertical capillary force of liquid on particles present on the surface of the substrate is in balance, for a single particle, with buoyancy and drag from the substrate, and does not produce force in the horizontal direction. The balance of this vertical force produces, however, asymmetry in the proximity of the particles, thus causing the production of excess force in the horizontal direction.

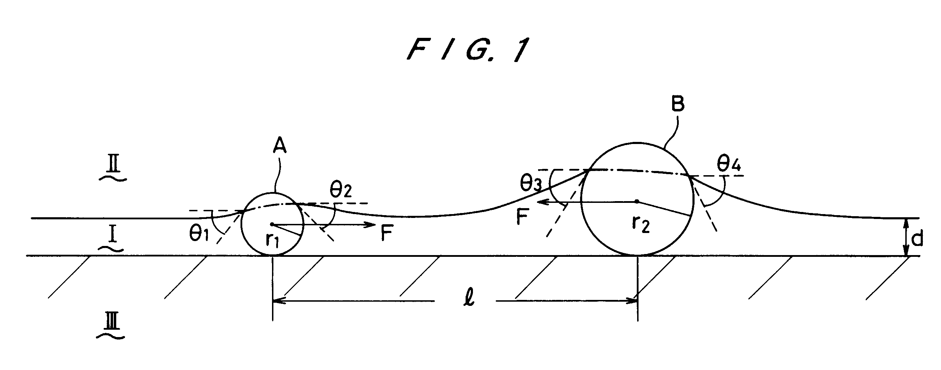

This is called the lateral capillary force (the lateral immersion force). More specifically, as shown in Fig. 1, by supplying particles (A) and (B) dispersed in a liquid dispersion medium (I) on a substrate (III) having a flat surface, and controlling the thickness (d) of the liquid dispersion medium (I) to the order of the particle size of the particles (A) and (B), (that is, to about the particle size) and particularly to below the particle size, a considerable attractive force (F) acts on the particles (A) and (B), thus forming crystal nuclei (aggregates) of the particles (A) and (B). This attractive force (F) may be called the lateral capillary force (lateral immersion force).

The lateral capillary force (lateral immersion force) is theoretically expected to be dependent on the contact angle (θ₁ - θ₄) between the particles (A) and (B) and the liquid dispersive medium (I), the thickness (d) of the liquid dispersion medium (I) at a sufficient long distance, the distance (1) between the particles (A) and (B), the radii (r₁, r₂) thereof, the interfacial tension (surface tension when the liquid dispersion medium is air) between the liquid dispersion medium (I) and the adjacent medium (II), and the difference in density between the liquid dispersion medium (I) and the medium (II). The lateral capillary force (lateral immersion force) is a force acting over a very long distance, and is estimated to be proportional to the reciprocal of the distance (1) between the particles, in the acting area defined by the capillaric constant. Because of this feature of being effective over a long distance, the attracting force acts on particles at a considerable distance.

The attracting force is stronger and the formation of particle aggregates or nuclei is accelerated according the ease with which the particles wetted by the liquid dispersion medium.

Crystal nuclei of the particles are formed on the substrate having a flat surface under the effect of the lateral capillary force (lateral immersion force) as described above.

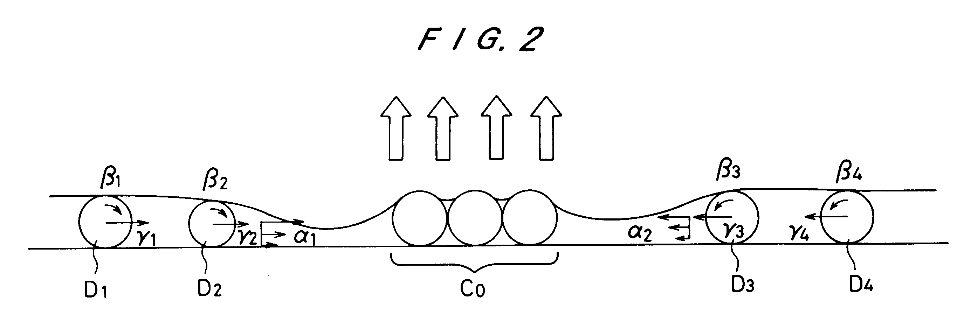

The formation of the particle structures by further growth depends, on the other hand, also upon laminar flow produced in the liquid dispersion medium (I), along with changes of liquid pressure, or by evaporation of liquid dispersion medium (I), as shown in Fig. 2. Even during this growing process, attractive force between the particles and the lateral immersion force continue to act.

The laminar flow will now be described with reference to Fig. 2. When the liquid dispersion medium (I) is evaporated, the amount of evaporation in the area near the crystal nuclei (Co) of the particles produced during the above-mentioned nucleation process increases, when the thickness of the liquid dispersion medium (I) falls below the particle size. Then, liquid in an amount equal to the decrement of the dispersion liquid flows in. More particularly, liquid flows in under the capillary effect to the crystal nuclei (Co) of the particles, and a laminar flow of liquid is established in the liquid dispersion medium. The flow velocity distribution (α₁, α₂) of this laminar flow indicates the highest velocity near the surface of the liquid dispersion medium, because of the small friction force between the liquid and the adjacent medium (II). The flow velocity becomes lower toward the substrate (III), thus producing a velocity gradient in the liquid dispersion medium. Rotational forces (β₁ - β₄) are thereby generated in the particles (D₁ - D₄). As a result, the particles are subjected to both rotational forces β₁ - β₄, and translational forces γ₁ - γ₄, and are moved toward the crystal nuclei (Co) while rolling on the substrate. These rotational forces and translational forces act, even when the particles are absorbed by the substrate, as a force peeling off absorbed particles, thus facilitating structure formation. Even when the scale of particle structure formation becomes sufficiently large, the growth process continues as long as the above-mentioned lateral immersion force and laminar flow continue to act in the structure forming region.

The laminar flow in the liquid dispersion medium (I) resulting from evaporation is strongest up to about 1 mm from the surface. The particulates should therefore preferably have a size of up to 1 mm.

There is no particular limitation on the kinds of particles and liquid dispersion media in the present invention; some typical examples are shown in Table 1.

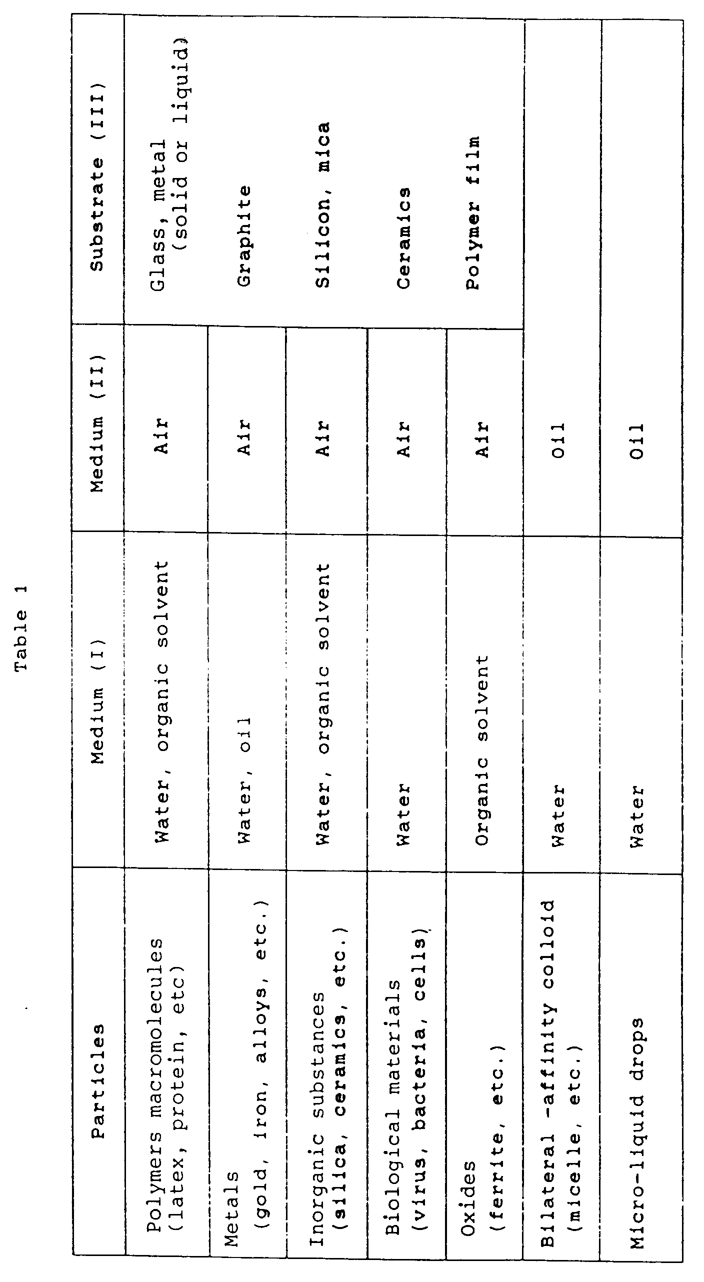

When the particle sizes are not uniform, the velocity distribution in the liquid dispersion medium is high near the surface, so that larger particles have a higher velocity than smaller particles. By utilizing this feature, it is possible to form a structure in which particles having smaller sizes are on the periphery.

The invention provides an effective means for particle structure formation even in space, where structure formation based on the gravity effect cannot be expected, since the lateral capillary force (lateral immersion force) and fluid force are valid even in the weightlessness condition.

The particle structures produced the method of the invention can be converted into useful film structures by fixing them in the form produced (for example by evaporation of the liquid medium), or by chemical modification (eg adhesion) or processing or modification with the use of laser or other light. It is also possible to convert layered structures into multi-layer structures. It is thus possible to apply the method of the present invention to provide new materials for use in such areas as electronics, biomaterials, ceramics, metal and polymer, including sensors, magnetic thin films, optical thin films and catalytic films, and also to new physical and chemical processes and measuring methods.

The invention will be described further in the following examples.

### EXAMPLE 1

Polystyrene latex particles having a maximum particle size of 1.75 µm, a minimum particle size of 1.65 µm, and an average particle size of 1.70 µm were used to form structured arrangements on a surface of glass.

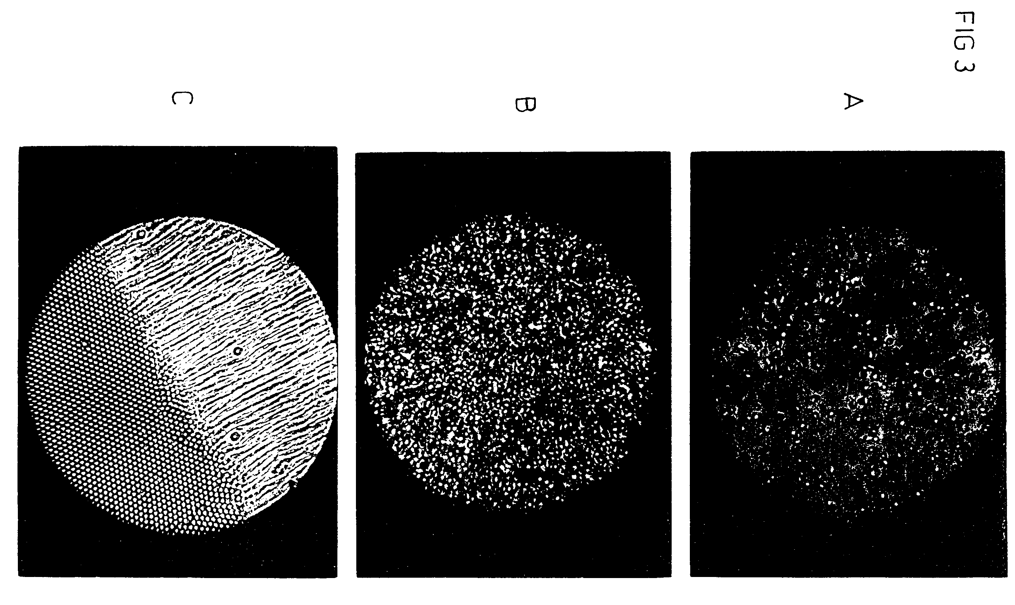

A solution of the polystyrene latex particles in distilled water was spread on a glass plate and the water evaporated. When the liquid thickness fell to 1.20 µm, formation of crystal nuclei grains was confirmed, and immediately thereafter, the formation of polystyrene latex particle structures began. A two-dimensional single layer of close-packed particles was formed. Fig. 3(a) and (b) illustrate the state of latex particles suspended in water, and Fig. 3(c) shows the particles projecting above the water surface when rapid structure formation commenced. A uniform particle layer was thus promptly formed.

### EXAMPLE 2

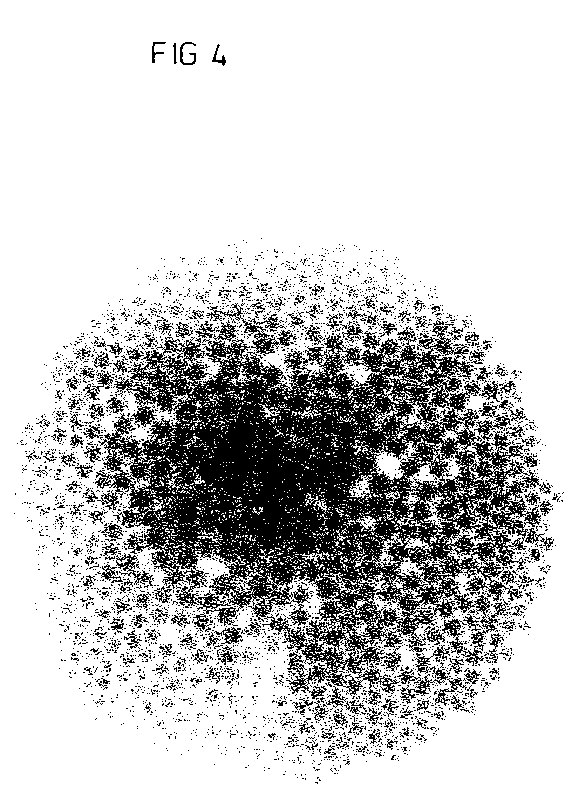

Fig. 4 illustrates another two-dimensional single particle layer. Polystyrene latex particles having a maximum particle size of 60 nm, a minimum particle size of 50 nm, and an average particle size of 55 nm were dispersed in water and formed into structured arrangements on the surface of Hg by evaporation of the water. The periphery is composed of particles having smaller sizes and the whole layer has a generally circular shape.

### EXAMPLE 3

The particles produced in Example 1 were fixed on the surface of the glass plate, as a substrate, by the complete evaporation of the liquid medium used. The fixed patterned particles were provided as single layer of the particles.

According to the present invention, it is possible to produce rapidly uniformly-ordered single particle layers. The particles are arranged in a two-dimensional structure, and the size of the structure can be controlled by controlling the thickness of the liquid dispersion medium containing the particles.

## Claims

1. A method for the formation of two-dimensional structures or arrangements of fine particles, which comprises forming a layer of a dispersion of the particles in a liquid medium on the surface of a substrate, characterised by reducing and controlling the thickness of said liquid layer to the order of the particle size or to less than the particle size, to form a thin liquid film and thereby cause the particles to assemble in a two-dimensional form.

2. A method as claimed in claim 1, wherein the thickness of the liquid layer is reduced by evaporating the liquid medium.

3. A method as claimed in claim 1 or claim 2 in which the initial size of the fine particles is up to 1mm.

4. A method as claimed in any preceding claim, wherein particles having different particle sizes are used and collect together with the particles having smaller sizes on the outside.

5. A method as claimed in any preceding claim in which the material produced is subsequently fixed.

## Patentansprüche

1. Verfahren zur Herstellung von zweidimensionalen Strukturen oder Anordnungen feiner Partikeln, das die Bildung einer Schicht einer Dispersion der Partikeln in einem flüssigen Medium auf der Oberfläche eines Substrates umfaßt, gekennzeichnet durch die Reduzierung und Steuerung der Dicke der flüssigen Schicht auf die Größe der Teilchengröße oder auf weniger als die Teilchengröße, um einen dünnen Flüssigkeitsfilm zu bilden und dadurch die Teilchen zu veranlassen, in zweidimensionaler Form zusammenzutreten.

2. Verfahren nach Anspruch 1, worin die Dicke der flüssigen Schicht durch Verdampfung des flüssigen Mediums reduziert wird.

3. Verfahren nach Anspruch 1 oder 2, worin die anfängliche Größe der feinen Partikeln bis zu 1 mm beträgt.

4. Verfahren nach einem der vorangegangenen Ansprüche, worin Partikeln mit unterschiedlichen Teilchengrößen verwendet werden und sich zusammen mit den Partikeln an der Außenseite, die kleinere Größen haben,ansammeln.

5. Verfahren nach einem der vorangegangenen Ansprüche, worin das hergestellte Material anschließend fixiert wird.

## Revendications

1. Procédé pour la formation de structures ou arrangements bidimensionnels de fines particules, qui comprend la formation d'une couche d'une dispersion des particules dans un milieu liquide sur la surface d'un substrat, caractérisé par la réduction et le contrôle de l'épaisseur de ladite couche de liquide jusqu'à l'ordre de la dimension de particules ou inférieur à la dimension de particules, pour former un film liquide mince et ainsi faire en sorte que les particules s'assemblent dans une forme bidimensionnelle.

2. Procédé selon la revendication 1, dans lequel l'épaisseur de la couche liquide est réduite par évaporation du milieu liquide.

3. Procédé selon la revendication 1 ou la revendication 2, dans lequel la dimension initiale des fines particules atteint jusqu'à 1 mm.

4. Procédé selon l'une des revendications précédentes, dans lequel on utilise des particules ayant des dimensions de particules différentes et on les assemble avec des particules de dimensions plus faibles vers l'extérieur.

5. Procédé selon l'une des revendications précédentes, dans lequel la matière produite est ensuite fixée.
